# EUROPEAN PATENT APPLICATION

(11) **EP 2 858 120 A1**
(43) Date of publication of application: **08.04.2015**
(21) Application number: 13425137.0
(22) Date of filing: 04.10.2013
(51) Int. Cl.: H01L 31/042, H01L 25/075

(54) **LED module for the conversion of sunlight or artificial light into electrical energy and method for manufacturing the same**

(71) Applicant: Chiacchieroni, Alfredo, 05010 San Venanzo (TR) (IT)
(72) Inventor: Alfredo CHIACCHIERONI, 05010 SAN VENANZO (IT); Chiacchieroni, Alfredo, SAN Venanzo (TR) (IT)
(74) Representative: Cioncoloni, Giuliana

(57) **Abstract**

A light-emitting diode module for the conversion of sunlight or artificial light into electrical energy comprises an array of base LEDs (E1s; E1p), connected in series to form rows that in turn are connected together in parallel by means of branches leading to output wires on which an inverter (5) for converting the direct current produced by irradiation into alternating current supplied to the electrical grid is provided. Mounted on each of the base LEDs (E1s; E1p) is mounted a plurality of piled LEDs (E2s ... Ens; E2p ... Enp) so as to form a stack of LEDs (E1s ... Ens; E1p ... Enp) electrically connected together.

## Description

The present invention relates to a light-emitting diode (LED) module for the conversion of sunlight or artificial light into electricity. Furthermore, the invention concerns a method for manufacturing said module.

It is well known that the LEDs, which are naturally light emitters, can act as solar cells albeit with a lower efficiency due to their small sizes compared to those of the photovoltaic cells. For this reason, in the past LEDs have been used as light sensors and not as photovoltaic cells. In fact, if a small number of LEDs are placed in a module, they do not give an appreciable yield because the efficiency of each LED in terms of current produced is very low. Instead, if series of a large number of LEDs are arranged in parallel, each row of each series achieves a peak current that determines the ignition of the LEDs and therefore the emission outside of the light energy caused by the flow of current, with a result opposite to that which was expected.

Previous patent applications by the same inventor, RM2011A000439 and PCT/IT2013/000187, describe a light-emitting diode photovoltaic module for the conversion of sunlight or artificial light into electrical energy, comprising an array of semiconductor conversion elements that are LEDs being arranged in rows, electrically connected in series and divided into groups in each row, the groups being separated from each other by a device able to limit current peaks capable of igniting the LEDs in successive groups. The rows of LEDs are connected between them in parallel at their ends by branches leading to output wires for the collection of the power provided to the electrical grid.

However, if compared with a presumed yield being declared as satisfactory in the Italian patent application cited above, the results of tests have shown that this yield can not be reached by a panel equipped with an array of LEDs being arranged in rows, and then only with a two-dimensional arrangement. Indeed, although a purpose of the inventions mentioned above is to provide a photovoltaic module having a very large number of LEDs, the achieved density of LEDs, namely the number of LEDs per surface unit, is insufficient to produce, by means of such a two-dimensional arrangement, an amount of energy comparable to that of traditional photovoltaic panels of the same surface,.

In this context, the technical task underlying the present invention is to propose a light-emitting diode module that overcomes the above mentioned drawbacks of the prior art.

In particular, an object of the present invention is to provide a module capable of supplying a quantity of electrical energy much greater than that obtained by a LED panel of the type described in the patent applications mentioned above.

Another object of the invention is to allow a LED module with the desired density of LED to be manufactured in a simple and rapid way.

In a first aspect of the invention, the technical task mentioned and the objects specified are substantially achieved by a light-emitting diode (LED) module, comprising an array of LEDs, connected in series to form rows that in turn are connected in parallel by means of branches leading to an output inverter, wherein mounted on each of the LEDs of said array of LEDs is a plurality of LEDs piled so as to form a stack of LEDs electrically connected together as defined in claims 1 to 9.

In a second aspect, a process for manufacturing a LED module is described according to claim 10 .

Further features and advantages of the present invention will become more apparent from the indicative, and therefore non-limiting description of a preferred, but not exclusive, embodiment of a LED module, as illustrated in the accompanying drawings in which:
- Figure 1 is a schematic perspective view in an enlarged scale of a photosensitive cell of a LED module according to the present invention;
- Figure 2 is a schematic top plan view of the photosensitive cell in Figure 1;
- Figure 3 is a side view of the photosensitive cell in Figure 1, components thereof being added;
- Figure 4 is a detailed partial perspective view of a top portion of a columnar element of the photosensitive cell in Figure 1;
- Figure 5 is a detailed partial perspective view of a base portion of a columnar element of the photosensitive cell in Figure 1;
- Figure 6 is a partial circuitry schematic view of a plurality of series-connected LEDs of the photosensitive cell in Figure 1;
- Figure 7 is a partial circuitry schematic view of a plurality of parallel-connected LEDs of the photosensitive cell in Figure 1;
- Figure 8 is a schematic view of the plurality of series-connected LEDs in Figure 6 to form a columnar element; and
- Figure 9 is a partial schematic view of the plurality of parallel-connected LEDs in Figure 7 to form a columnar element.

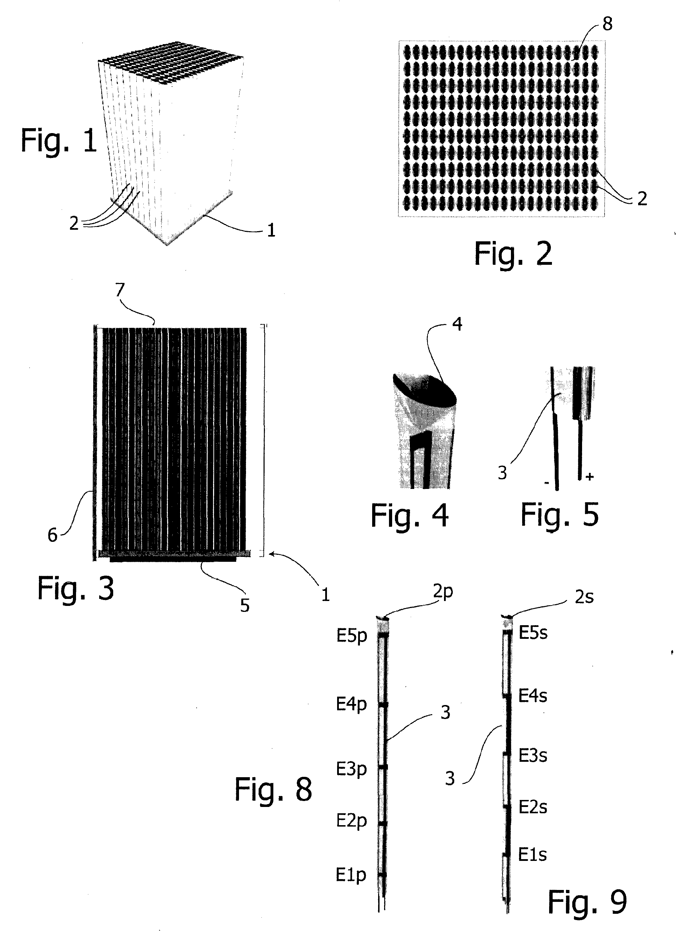

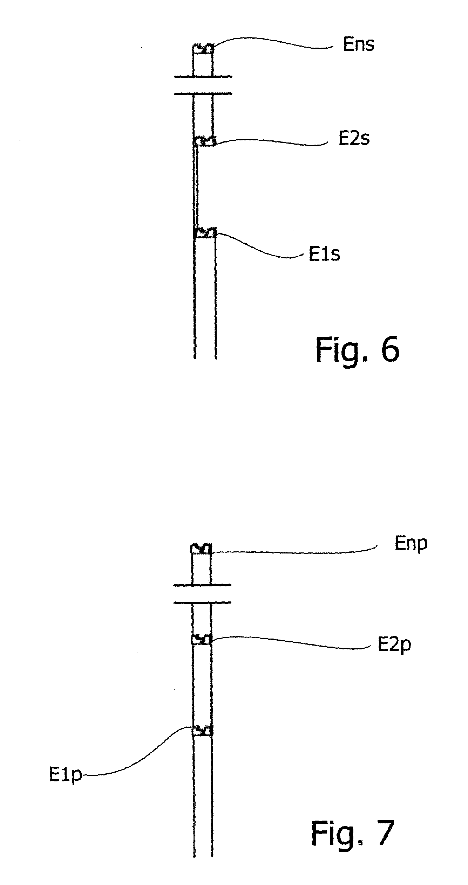

Reference is initially made to Figure 1, which is a schematic perspective view in an enlarged scale of a photosensitive cell as a part of a LED module according to the present invention. By way of example, the photosensitive cell includes a base formed by a printed circuit board 1; the printed circuit board 1 has a square shape of about 4 cm². Mounted on the printed circuit board 1 is an array of light-emitting diodes (LEDs), hereafter called base LEDs, whose pins, which are indicated as + and - in the partial perspective view of Figure 5, are connected in series to form rows which in turn are connected together in parallel by means of branches leading to output wires. This arrangement (not represented) is already known from patent application RM2011A000439, which is included here as a reference. Called generally as E1 are LEDs of the base LED array in contact with the printed circuit board 1. According to the present invention, mounted on each base LED E1 is a plurality of LEDs superimposed so as to form a stack of LEDs that are electrically connected together. Each LED of each stack overlying the base LED E1 can be connected to the base LED E1, which is indicated as E1s, if such a connection is in series, and as E1p, if the connection is in parallel, in Figures 6 and 7. In these figures, which are schematic partial circuitry views of a plurality of n LEDs of a stack, the LEDs being connected successively in series and in parallel, indicated as E1s ... Ens are the LEDs connected in series and, respectively, E1p ... Enp, the LEDs connected in parallel. The stack of LEDs, be they connected in series or in parallel, captures light energy, in particular sunlight energy according to the present invention.

Shown in Figures 8 and 9, which are a partial schematic view of the plurality of LEDs connected in series and in parallel, respectively of Figures 6 and 7, are five series-connected LEDs E1s, E2s , E3s , E4s , E5s, and five parallel-connected LEDs E1p, E2p, E3p, E4p, E5p, respectively, which form columnar elements wholly indicated as 2s and 2p because the circuitry components of the LEDs with connections thereof are embedded in a coating 3 of a first transparent plastic material having a high resistance.

The columnar elements, generically indicated as 2 in Figure 1, are mounted on the printed circuit board 1. Shown in Figure 2, which is a schematic top plan view of the photosensitive cell in Figure 1, are the columnar elements 2 of the photosensitive cell in their preferred cross-section shape that is elliptical. Preferably, the major axis of the elliptical section is 1.95 mm long, while the minor axis is 1.2 mm long. The height of the columnar element is 30 mm.

Each columnar element ends at the top with a concavity facing upward as shown in detail in Figure 4, which is a partial perspective view of a top portion of a columnar element 2 of the photosensitive cell of Figures 1 and 2. The concavity, indicated as 4, allows solar energy to be conveyed onto the columnar element in order to strike all the LEDs of the stack being embedded within the first plastic material. The lighting of the LEDs is favoured by the transparency of the plastic material.

As mentioned above, each columnar element 2 is associated with the printed circuit board 1 that is common to the columnar elements of the module. The printed circuit board 1, which allows the electrical connection of the stacks of LEDs of each columnar element, has a bottom in which an inverter 5 is embedded for converting the direct current produced by irradiation into alternating current that is supplied to the electrical grid. This is shown in Figure 3, which is a side view of the photosensitive cell in Figure 1. Added to the photosensitive cell is a protective casing being made by an aluminium frame 6 and a sheet of tempered glass 7 with relevant gaskets (not shown).

Inside the protective casing, the columnar elements 2 of the photosensitive cell of the LED module are embedded in a second transparent plastic material 8 having high thermal conductivity so as to act as a solar panel. The plastic material can be preferably an epoxy resin.

The manufacturing method of the LED module according to the present invention, for the conversion of sunlight or artificial light into electrical energy, comprises the steps that are described in the following.

A plurality of stacks of electrically series or parallel connected LEDs by means of two conductors from a top LED to a base LED, which is equipped with two pins, is manufactured. Each stack of LEDs is embedded in a coating 3 of the first high resistance transparent plastic material so as to form a columnar element 2 ending at the top with a concavity 4 facing upward, and downward with the pins + and - of the base LED, the pins + and - protruding from the plastic coating 3. The pins of the plurality of base LEDs are joined to a printed circuit board 1 and connected in series to form rows that, in turn, are connected together in parallel by means of branches leading to output wires on which an inverter 5 is provided for transforming direct current produced by irradiation into alternating current supplied to the electrical grid. The inverter 5 is preferably embodied in the printed circuit board 1. Then, the plurality of columnar elements 2 is embedded in a second high conductivity transparent plastic material 8 in a manner as to form a compact solar panel, which is mounted on an aluminium frame 6 with protection gaskets and covered with a sheet 7 of tempered glass.

To provide a broad indication about the yield of the LED module according to the present invention it has been calculated that by obtaining a power of 0.0025 W from each columnar element, since the number of elements in 1 m² of the panel is 425,530, the gross power produced by 1 m² of the panel is about 1063 W. Supposing that system losses are 10%, net power produced by 1 m² of the panel is 956 W.

The advantages of the LED module according to the present invention are many and considerable: absence of silicon; increasing of the service life of a plant using said module; high capacity of capturing solar irradiation; installation with any orientation with respect to the sun; multiplicity of forms and sizes; costs similar to those of traditional photovoltaic technology; lack of specific costs of disposal; reduced installation costs; presence of an inverter in the module.

Obviously, the main advantage is a smaller surface, the energy produced being the same, as compared to the traditional silicon semiconductor photovoltaic panels. In fact, using LED modules permits to multiply the layers that absorb sunlight, by stacking a large number of LEDs. The underlying layers are only penalised by those overlying because sunlight passes through the coatings of transparent plastic material provided in the present invention.

## Claims

1. A LED module for the conversion of sunlight or artificial light into electrical energy, comprising an array of base light-emitting diodes (LEDs) (E1s; E1p) connected in series to form rows that in turn are connected together in parallel by means of branches leading to output wires on which an inverter (5) for converting the direct current produced by irradiation into alternating current supplied to the electrical grid is provided, **characterised in that** mounted on each of the base LEDs (E1s; E1p) is a plurality of piled LEDs (E2s ... Ens; E2p ... Enp) so as to form a stack of LEDs (E1s ... Ens; E1p ... Enp) electrically connected together.

2. The module according to claim 1, **characterised in that** the LEDs (E1s ... Ens) of said stack are connected together in series.

3. The module according to claim 1, **characterised in that** the LEDs (E1p ... Enp) of said stack are connected together in parallel.

4. The module according to claim 1, **characterised in that** each stack of LED is embedded in a first high resistance transparent plastic material (3) so as to form a columnar element (2).

5. The module according to claim 4, **characterised in that** said columnar element (2) has an elliptically shaped cross-section.

6. The module according to claim 4, **characterised in that** each columnar element (2) ends at the top with a concavity (4) facing upwards.

7. The module according to claim 4, **characterised in that** each columnar element (2) is associated with a printed circuit board (1) being common to the columnar elements (2) of the module, said printed circuit board (1) having a bottom on which said inverter (5) is embedded.

8. The module according to claim 7, **characterised in that** said columnar elements (2) of the module are embedded in a second high conductivity transparent plastic material (8) in a manner as to form a solar panel.

9. The module according to claim 8, **characterized in that** said solar panel is mounted on an aluminium frame (6) and covered with a sheet (7) of tempered glass.

10. A method for manufacturing a light-emitting diode (LED) module, for the conversion of sunlight or artificial light into electrical energy, comprising the following steps:
- manufacturing a plurality of stacks of LEDs (E1s ... Ens; E1p ... Enp) electrically connected in series or in parallel between them by means of two conductors from a top LED to a base LED being equipped with two pins (+ and -);
- embedding each stack of LED (E1s ... Ens; E1p ... Enp) in a first high resistance transparent plastic material (3) so as to form a columnar element (2), ending at the top with a concavity (4) facing upwards, the pins (+ and -) of the base LED (E1s; E1p) protruding downward from said first plastic material (3);
- merging to a printed circuit board (1) the pins (+ and -) of the plurality of the series-connected base LEDs (E1s; E1p) to form base rows that in turn are connected together in parallel by means of branches leading to output wires for an inverter (5) transforming current continuous produced by irradiation into alternating current supplied to the electrical grid;
- embedding the multiplicity of columnar elements (2) in a second high conductivity transparent plastic material (8) in a manner as to form a solar panel;
- providing said inverter in the printed circuit board (1) on the opposite side of the solar panel; and
- mounting the solar panel on an aluminium frame (6) with protective gaskets and covering the same with a sheet (7) of tempered glass.
